# FASCICULE DE BREVET EUROPEEN

(11) **EP 0 237 100 B1**
(45) Date de publication et mention de la délivrance du brevet: **13.10.1993**
(21) Numéro de dépôt: 87200295.1
(22) Date de dépôt: 23.02.1987
(51) Int. Cl.: G01R 13/20, G01R 13/32, H01J 31/08, G11C 27/02

(54) **Dispositif d'enregistrement et de restitution de signaux électriques muni d'un prédéclenchement, comprenant un dispositif à transfert de charges**
Mit einer Frühtriggerung versehene Schaltung zur Registrierung und Wiederherstellung elektrischer Signale, die Ladungsübertragungselemente enthält
Device for registering and reconstructing electrical signals, comprising a pretrigger circuit and charge-coupled devices

(30) Priorité: 28.02.1986 FR 8602822
(43) Date de publication de la demande: 16.09.1987
(73) Titulaire: LABORATOIRES D'ELECTRONIQUE PHILIPS, 94450 Limeil-Brévannes (FR); Philips Electronics N.V., 5621 BA Eindhoven (NL)
(72) Inventeur: Piaget, Claude Société Civile S.P.I.D., F-75007 Paris (FR)
(74) Mandataire: Landousy, Christian

(56) Documents cités:
- EP-A- 0 036 340
- FR-A- 2 331 794
- SU-A- 1 150 677
- US-A- 3 506 971

## Description

L'invention concerne un dispositif d'enregistrement et de restitution de signaux électriques à analyser, comprenant un tube à vide muni d'un canon à électrons émettant un faisceau d'électrons soumis à l'action des signaux électriques à analyser et contrôlé par un système de focalisation et de déflexion de faisceau, afin d'inscrire sur les zones sensibles de deux matrices de dispositifs à transfert de charges sous la forme de charges stockées, la trace des signaux électriques à analyser, les charges stockées étant extraites du tube, à l'aide de registres de lecture, pour être traitées dans des moyens de traitement puis visualisées sous forme de signaux électriques restitués sur un écran de visualisation.

Une invention de ce type est connue du document soviétique SU 1150677. Il décrit un appareil comprenant une source d'électrons, un système de focalisation et de déviation du faisceau électronique et une cible formée de deux matrices de dispositifs à transfert de charges DTC. Un dispositif de sélection oriente vers l'un ou l'autre DTC le faisceau d'électrons dont le courant est modulé selon un signal d'entrée à analyser. Les deux DTC sont disposés l'un au-dessus de l'autre de sorte que la frontière qui les sépare soit parallèle à la direction horizontale du balayage effectué par une base de temps. Le faisceau d'électrons, qui est modulé en intensité par le signal vient ainsi inscrire son information sur chaque DTC sur les zones sensibles constituées de deux ou trois rangées du DTC situées de part et d'autre de cette frontière. La quantité de charges déposées en chaque point de cette zone à 2 ou 3 rangées et ainsi représentative du signal à analyser.
Le faisceau d'électrons, bien que focalisé, est néanmoins suffisamment large pour écrire sur 2 ou 3 rangées à la fois, sur l'un des DTC à l'aller, puis sur l'autre DTC au retour, et ainsi de suite d'une manière ininterrompue. Lorsque les charges ont été déposées sur les 2 ou 3 rangées indiquées, elles sont transférées et additionnées selon les colonnes du DTC vers un registre de sortie à l'aide de différentes horloges. Les registres de chaque DTC opèrent en alternance, dans des sens opposés correspondant à leur inscription, pour évacuer leurs charges vers un amplificateur de sortie lui-même relié à un dispositif de traitement et de visualisation.

Cet art antérieur a pour but d'accroître la précision de conversion du signal à analyser, d'augmenter le volume des signaux enregistrés, de réaliser une conversion ininterrompue avec une vitesse d'inscription inférieure à la vitesse de transfert des charges par les registres de sortie.

Ce dispositif peut être utilisé dans des systèmes automatisés de contrôle et de visualisation d'informations ou dans des systèmes oscillographes, mais il ne présente pas une vitesse de fonctionnement élevée nécessaire aux oscilloscopes modernes.

D'autre part, il n'offre pas à l'utilisateur la possibilité d'effectuer le prédéclenchement ce qui est très utile et apprécié par les utilisateurs d'oscilloscopes. Le prédéclenchement consiste en la chose suivante. Dans un oscilloscope afin d'obtenir une image stable sur l'écran, sa base de temps est déclenchée par le signal à observer lui-même selon des seuils que l'on peut modifier. Ce signal doit donc avoir un niveau suffisant pour effectuer ce déclenchement. Les évènements du signal qui se sont produits juste avant l'instant de déclenchement sont donc perdus. En particulier lorsque le signal est un signal monocoup, donc non récurrent, une partie de l'information contenue dans le signal ne peut être observée. Le prédéclenchement consiste donc à permettre de conserver en mémoire des échantillons qui vont se situer de part et d'autre de l'instant de déclenchement. Il ne reste plus ultérieurement qu'à restituer sur un écran de visualisation la forme du signal ainsi mémorisé.

Cet art antérieur ne propose pas de solution pour effectuer la mémorisation avec prédéclenchement.

On connaît également le document français FR-2 331 794 qui concerne un dispositif d'analyse d'un signal ultrarapide qui sert à moduler l'intensité d'un faisceau électronique/optique qui balaye un dispositif DTC. Les charges stockées dans chaque cellule sont ainsi proportionnelles à l'amplitude du signal ultrarapide. Le dispositif DTC est formé d'une (plusieurs) barrette(s) de cellules balayées par le faisceau, le prélèvement effectué par chaque cellule constituant un échantillonnage. Comme le document soviétique SU-1 150 677, il utilise le même principe d'inscription dans plusieurs barrettes de DTC. Le document FR 2 331 794 ne dispose d'aucun moyen pour opérer l'analyse avec prédéclenchement de signaux non récurrents.

Un but de l'invention est donc de permettre un prédéclenchement du signal dans une large gamme de fréquences élevées pour un oscilloscope à traitement numérique du signal.

Pour cela l'invention telle que définie dans le préambule est remarquable en ce que les deux matrices de dispositifs à transfert de charges sont juxtaposées par leur zone sensible sans discontinuité selon une frontière sensiblement perpendiculaire à la direction de balayage X correspondant à la déflexion de base de temps, le faisceau d'électrons étant défléchi, selon une direction Y sensiblement perpendiculaire à la direction X, par les signaux électriques à analyser, de sorte que la trace issue du faisceau agit alternativement sur les surfaces des zones sensibles des deux matrices de dispositifs à transfert de charges selon des séquences de balayage d'écriture aller-retour qui sont arrêtées par l'apparition d'un signal de déclenchement, à l'achèvement du cycle d'écriture de la matrice sur laquelle s'effectuait l'écriture, afin de réaliser un dispositif d'enregistrement et de restitution à prédéclenchement, permettant de capter en permanence les signaux électriques à analyser et de les traiter par les moyens de traitement pour fournir un signal restitué correspondant à la partie du signal à analyser qui précède et qui suit l'apparition du signal de déclenchement.

Elle est également remarquable en ce que ce dispositif peut être utilisé dans un oscilloscope disposant ainsi d'un prédéclenchement. Le courant de faisceau du tube peut être modulé pour inscrire localement dans le DTC une quantité de charges, afin de créer sur l'écran de visualisation une surbrillance définissant l'état d'un drapeau correspondant au sens de balayage du DTC par le faisceau. Le courant de faisceau du tube peut également être modulé pour inscrire localement dans le DTC, une autre quantité de charges, afin de créer sur l'écran de visualisation une autre surbrillance définissant l'instant de déclenchement.

L'invention met à profit le fait qu'un DTC peut être effacé beaucoup plus rapidement globalement que lors de la lecture normale de l'image.

Le dispositif selon l'invention est constitué d'une enveloppe à vide qui contient un canon à électrons émettant un faisceau d'électrons d'écriture qui peut être défléchi selon une direction par le signal à analyser et selon la direction orthogonale par une base de temps.

Selon un premier mode de réalisation le faisceau d'électrons excite le phosphore d'un écran du tube en fournissant une trace qui est reprise par une plaque de fibres optiques à la sortie de laquelle sont fixés les DTC qui sont ainsi excités en mode photosensible. Cette plaque de fibres optiques peut être constituée d'une plaque réductrice pour adapter le champ de l'écran au champ utile des DTC.

Selon un second mode de réalisation le faisceau d'électrons excite directement les DTC selon un mode électronosensible.

Selon les deux modes, les deux matrices de DTC sont juxtaposées de sorte que l'espace qui les sépare soit le plus faible possible. Les DTC sont organisés usuellement selon une zone sensible au rayonnement lumineux ou au faisceau d'électrons, et une zone masquée utilisée pour la lecture de la zone sensible. Les deux DTC sont ainsi juxtaposés par leur zone sensible.

L'invention peut aussi mettre à profit la mémoire de trame d'un DTC à transfert de trame pour accroître le taux de prédéclenchement.

Les deux matrices de DTC peuvent être formées d'un double DTC réalisé dans le même substrat. Dans le cas du premier mode de réalisation, le champ optique de l'écran du tube doit être adapté au champ optique des zones sensibles des deux matrices de DTC ou du double DTC. Cette adaptation se fait respectivement à l'aide de une ou deux plaques de fibres optiques réductrices selon que l'on a un double ou deux DTC. Lorsqu'il y a deux DTC, la discontinuité entre leurs deux champs optiques doit être la plus faible qu'il est technologiquement possible de réaliser.

Le balayage des deux matrices de DTC s'effectue selon une procédure d'aller-retour pendant laquelle l'écriture est effectuée. Chaque cellule de stockage des DTC est donc écrite indépendamment des autres cellules, mais par contre la lecture des charges stockées s'effectue selon une lecture successive par lignes ou par colonnes avec transfert de charges selon le mode propre au DTC utilisé. L'effacement des DTC est effectué séquentiellement de telle sorte qu'une matrice est effacée pendant que l'autre est inscrite. S'il s'agit d'un double DTC, celui-ci doit avoir les deux zones sensibles parfaitement juxtaposées mais chacune d'elle est lue et effacée à l'aide de ses propres circuits disposés sous une zone masquée.

En l'absence de signal de déclenchement l'effacement de chacune des deux matrices de DTC peut se faire soit par transfert de l'image dans la zone mémoire de celles-ci, lorsqu'il s'agit de matrices à transfert de trame, soit par effacement global en appliquant les impulsions de tension adéquates sur les électrodes de commande de transfert de la zone sensible. La première méthode nécessite une durée d'environ 1 ms et réduit donc la bande passante du système à quelques dizaines de kHz mais la seconde, en réalisant l'effacement en environ 1 microseconde, accroît la bande passante à plusieurs dizaines de MHz.

Selon l'instant où le signal de déclenchement apparaît au cours de la phase d'écriture, la partie du signal précédent cet instant est déjà inscrite sur une partie du DTC qui est en cours d'écriture et sur l'ensemble de l'autre, de sorte que la durée de la phase d'écriture peut être déterminée afin que soit visualisée toute la partie de signal souhaitée.

L'opération d'écriture se faisant à l'aide de séquences d'aller-retour, le signal écrit dans le DTC se trouve ainsi replié sur lui-même à chaque changement de direction du balayage. Les deux traces qui se trouvent stockées simultanément dans un DTC sont aisément différenciées à l'aide d'un drapeau qui suit la direction du balayage. Les échantillons du signal à analyser sont stockés dans les cellules élémentaires du DTC, sous la forme d'une densité de charges aux adresses X, Y correspondant aux paramètres temps, amplitude, selon les usages en oscilloscopie. L'intensité du faisceau électronique peut être utilisée pour inscrire, dans les cellules, l'état du drapeau par une différence d'intensité qui peut aussi elle-même être utilisée pour y inscrire le repère correspondant à l'instant de déclenchement. L'unité de traitement, qui traite ces données afin de les visualiser, tient compte du drapeau pour rétablir sur l'écran de visualisation l'allure correcte du signal à analyser.

L'invention sera mieux comprise à l'aide des figures suivantes données à titre d'exemple non limitatifs et qui représentent :
figure 1 : une vue schématique en perspective des éléments essentiels partiellement ouverts, d'un tube oscilloscope de type connu,
figure 2 : une représentation schématique de la disposition de deux matrices de DTC juxtaposées selon l'invention,
figure 3 : une séquence d'écriture en fonction du temps, formée de balayages aller-retour de la surface des matrices juxtaposées, ainsi que les variations du courant de surbrillance,
figure 4 : une disposition des deux matrices de DTC couplées à l'écran à l'aide de deux plaques réductrices à fibres optiques selon un mode photosensible,
figure 5 : une dispositif analogue à la figure 4 fais avec une double matrice de DTC,
figure 6 : une disposition d'une double matrice de DTC en mode électronosensible.

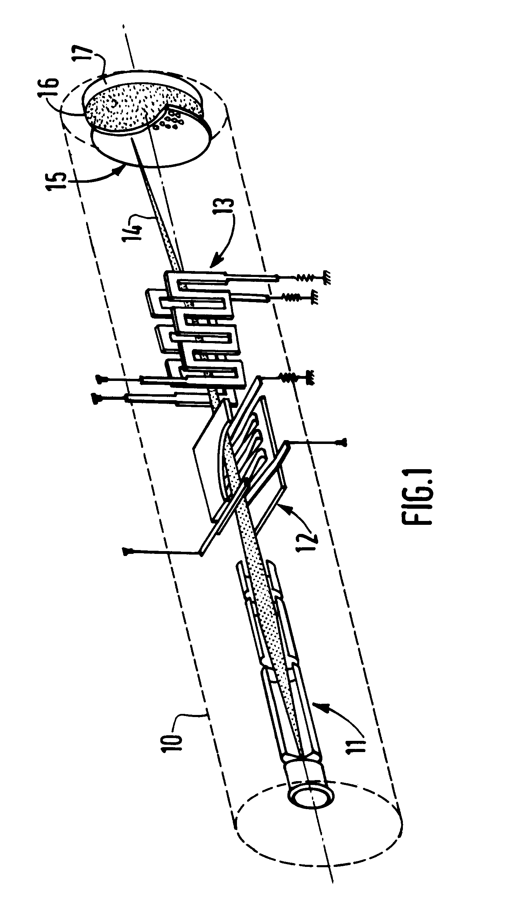

La figure 1 représente un tube oscilloscope de type connu. Dans une enveloppe à vide 10 est placé un canon à électrons 11 muni de plusieurs électrodes qui émet un faisceau d'électrons qui peut être défléchi par des moyens de déflexion de signal 12 selon une direction verticale et des moyens de déflexion de base de temps 13 selon une direction horizontale. Le faisceau d'électrons défléchi 14 pénêtre éventuellement dans une galette de microcanaux 15 qui accroît le nombre d'électrons. Ceux-ci viennent exciter le phosphore 16, déposé sur un écran 17, qui émet un flux lumineux selon une trace d'écriture. L'écran du tube est constituée d'une plaque de fibres optiques qui dirige le flux lumineux émis vers un DTC sur lequel s'effectue l'écriture de l'image du signal à analyser.

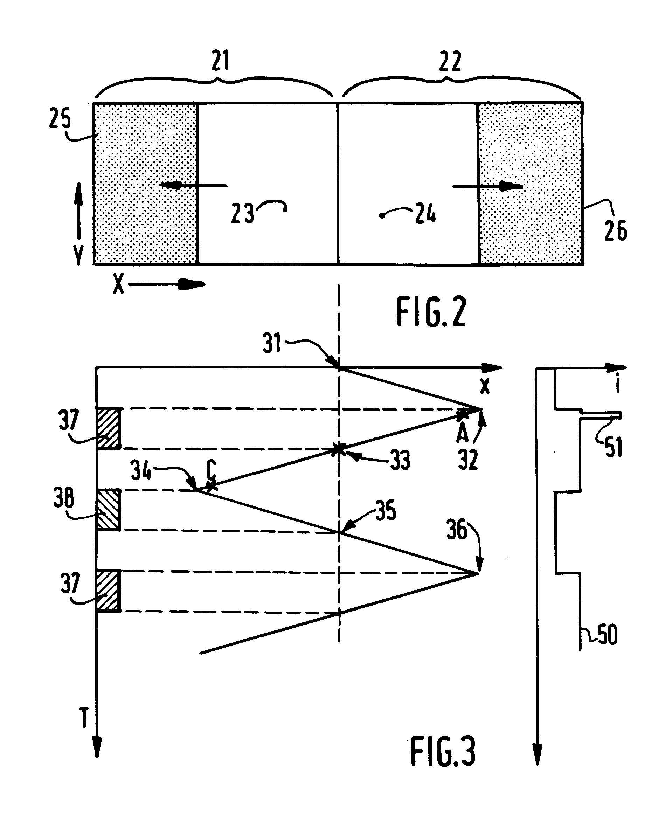

Pour effectuer le prédéclenchement, l'invention introduit l'usage d'une deuxième matrice de DTC, la frontière entre les deux matrices étant sensiblement perpendiculaire à la direction de balayage X correspondant à la base de temps. Ceci est représenté schématiquement sur la figure 2. Les deux matrices 21 et 22 sont juxtaposées de telle sorte que leurs zones sensibles respectives 23 et 24 apparaissent, vues à partir du canon du tube, sans chevauchement ni discontinuités. Ces zones sensibles 23 et 24 sont lues ou effacées à l'aide de circuits appropriés placés généralement à leur périphérie dans les zones masquées respectives 25 et 26. Celles-ce peuvent néanmoins être imbriquées dans les zones sensibles 23 et 24.

Le balayage dans le temps des zones sensibles 23 et 24 s'effectue selon le diagramme de la figure 3. Le sens du balayage à la surface des deux matrices s'effectue selon la direction X ou selon la direction opposée. Le déroulement du temps est représenté par l'axe T. Supposons qu'à l'instant initial l'écriture s'opère au centre des deux matrices représenté par le point 31. Le balayage s'effectue vers la droite jusqu'à l'extrémité de la matrice 24 et atteint le point 32 où le balayage rebrousse chemin. Une deuxième écriture s'effectue sur la matrice 24, puis une première écriture s'effectue sur la matrice 23. A l'extrémité de celle-ci le balayage atteint le point 34 où il rebrousse chemin à nouveau pour atteindre le point 36 et ainsi de suite. Au cours d'une séquence complète représentée par le trajet 31, 32, 33, 34, 35, 36 deux écritures ont été faites sur chaque matrice. Il est souhaitable de ne pas superposer plus de deux traces par matrice afin de ne pas trop compliquer les problèmes ultérieurs de lecture. Dans ce cas il faut opérer des effacements alternés des deux matrices. L'effacement d'une matrice est effectué juste avant que cette matrice ne soit écrite. Ainsi sur la figure 3 l'effacement de la matrice 23 est effectué au cours de la période représentée par le repère 37 et doit être terminé au repère 33. De même l'effacement de la matrice 24 est effectué au cours de la période représentée par le repère 38 et doit être terminé au repère 35. Cet effacement global individuel des DTC s'effectue en un temps inférieur à sensiblement 10⁻⁴ fois le temps de lecture de l'image. Il peut être très court, de l'ordre de 1 microseconde.

Pour la mise en oeuvre du prédéclenchement, le signal de déclenchement va pouvoir arriver à un instant quelconque de la séquence. Si le signal de déclenchement arrive à l'instant représenté par la lettre C le balayage d'écriture doit être poursuivi jusqu'au temps représenté par le repère 35. L'information déjà écrite au cours de la séquence 31-32-33-34-35 est stockée dans les deux matrices. Ainsi il y a environ 3 traces et 1 trace pour représenter les signaux respectivement précédant ou succédant au signal de déclenchement. Si celui-ci apparaît à l'instant correspondant au repère 33, il y aura dans les deux cas 2 traces pour représenter les signaux précédant ou succédant au signal de déclenchement. Si celui-ci apparaît à l'instant A il y aura 1 trace et 3 traces pour représenter les signaux précédant et succédant au signal de déclenchement.

Pour différencier les deux traces qui sont inscrites dans le DTC, le courant de faisceau est modulé sur deux niveaux de courant afin d'inscrire localement des quantités de charges supplémentaires. Ceci est représenté par la courbe 50 représentant les variations du courant de faisceau avec le temps. Ces deux niveaux vont être traduits en niveaux logiques 0 et 1 définissant ainsi un drapeau. A la restitution il apparaît ainsi une surbrillance sur l'écran de visualisation. En plus de cette modulation, une autre surbrillance peut être superposée pour définir l'instant de déclenchement. Ainsi sur la figure 3 un courant élevé 51 de courte durée est représenté à l'instant d'apparition d'un signal de déclenchement en A.

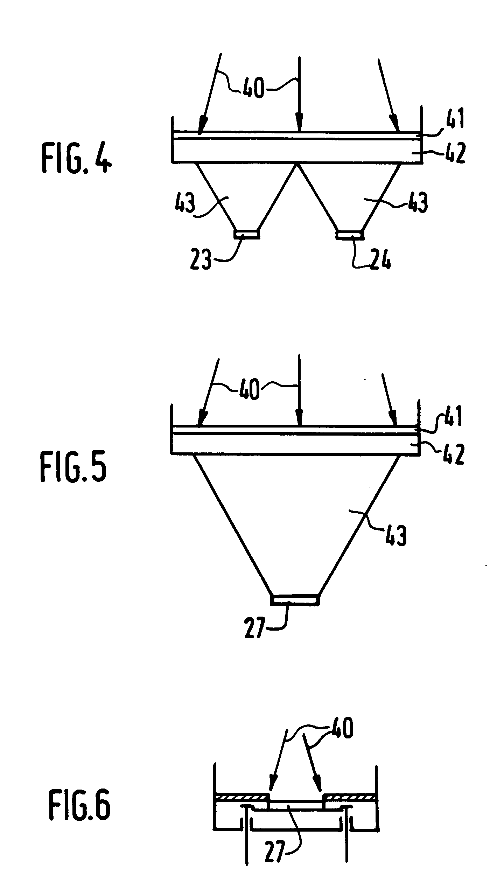

La figure 4 représente un mode de montage de deux matrices 23 et 24. Le faisceau d'électrons 40 arrive sur l'écran luminescent 41 déposé sur une plaque de fibres optiques 42 servant de support. Les dimensions des matrices de DTC étant très faibles (environ 6 x 5 mm) devant les dimensions de l'écran du tube, il est nécessaire d'adapter les champs optiques. Ceci est réalisé à l'aide de plaques de fibres optiques à concentration 43 qui adaptent sans discontinuités ni chevauchements les deux champs optiques.

Dans le cas où les deux matrices sont confondues en un double DTC la solution est analogue. Elle est représentée sur la figure 5 avec les mêmes repères et le double DTC 27.

Il est également possible d'utiliser un double DTC 27 selon le mode électronosensible représenté sur la figure 6. Dans ce cas le faisceau d'électrons 40 agit directement sur le DTC 27 où des charges électriques sont stockées de manière analogue.

Lorsque la séquence d'écriture a été arrêtée par l'arrivée du signal de déclenchement à l'achèvement du balayage du DTC sur lequel s'effectuait l'écriture, les charges stockées sont lues à l'aide des circuits placés dans les zones masquées des DTC et le traitement du signal est effectué à l'aide d'un dispositif de traitement qui exploite l'état du drapeau qui évolue avec le balayage aller ou retour propre à chaque matrice.

## Revendications

1. Dispositif d'enregistrement et de restitution de signaux électriques à analyser, comprenant un tube à vide (10) muni d'un canon à électrons (11) émettant un faisceau d'électrons soumis à l'action des signaux électriques à analyser et contrôlé par un système de focalisation et de déflexion de faisceau (12, 13), afin d'inscrire sur les zones sensibles (23, 24) de deux matrices de dispositifs (21, 22) à transfert de charges sous la forme de charges stockées, la trace (31-36) des signaux électriques à analyser, les charges stockées étant extraites du tube, à l'aide de registres de lecture, pour être traitées dans des circuits de traitement puis visualisées sous forme de signaux électriques restitués sur un écran de visualisation caractérisé en ce que les deux matrices (21, 22) de dispositifs à transfert de charges sont juxtaposées par leur zone sensible (23, 24) sans discontinuité selon une frontière sensiblement perpendiculaire à la direction de balayage X correspondant à la déflexion de base de temps, le faisceau d'électrons étant défléchi, selon une direction Y sensiblement perpendiculaire à la direction X, par les signaux électriques à analyser, de sorte que la trace issue du faisceau agit alternativement sur les surfaces des zones sensibles (23, 24) des deux matrices de dispositifs à transfert de charges selon des séquences (31-36) de balayage d'écriture aller-retour qui sont arrêtées par l'apparition d'un signal de déclenchement (51), à l'achèvement du cycle d'écriture de la matrice sur laquelle s'effectuait l'écriture afin de réaliser un dispositif d'enregistrement et de restitution à prédéclenchement, permettant de capter en permanence les signaux électriques à analyser et de les traiter par les moyens de traitement pour fournir un signal restitué correspondant à la partie du signal à analyser qui précède (31, 32) (31-34) et qui suit (32-35) (34, 35) l'apparition du signal de déclenchement (51).

2. Dispositif d'enregistrement et de restitution selon la revendication 1, caractérisé en ce que les deux dispositifs (21, 22) à transfert de charges sont formés d'un double dispositif (27) à transfert de charges réalisés dans le même substrat.

3. Dispositif d'enregistrement et de restitution selon une des revendications 1 ou 2, caractérisé en ce que le faisceau d'électrons, défléchi par les moyens de déflexion (12, 13), agit directement sur la surface des dispositifs à transfert de charges (21, 22) selon un mode électronosensible.

4. Dispositif d'enregistrement et de restitution selon une des revendications 1 ou 2, caractérisé en ce que le faisceau d'électrons défléchi par les moyens de déflexion (12, 13) balaye un écran (17) cathodoluminescent dont la trace lumineuse émise balaye la surface des dispositifs à transfert de charges selon un mode photosensible.

5. Dispositif d'enregistrement et de restitution selon la revendication 4, caractérisé en ce que chaque dispositif (21, 22) à transfert de charges est couplé à l'écran (41) à l'aide de fibres optiques (42, 43) qui adaptent, sans discontinuité, la totalité du champ optique de l'écran aux champs optiques des zones sensibles (23, 24) des dispositifs à transfert de charges.

6. Dispositif d'enregistrement et de restitution selon une des revendications 1 à 5, caractérisé en ce que le courant de faisceau du tube est modulé (50) pour inscrire localement une quantité de charges dans le DTC, afin de créer une surbrillance sur l'écran de visualisation, définissant l'état d'un drapeau correspondant au sens de balayage du DTC par le faisceau.

7. Dispositif d'enregistrement et de restitution selon la revendication 6, caractérisé en ce que le courant de faisceau du tube est modulé (51) pour inscrire une autre quantité de charges dans le DTC, afin de créer une autre surbrillance sur l'écran de visualisation, définissant l'instant de déclenchement.

## Claims

1. A device for storing and reproducing electric signals to be analyzed, said device comprising a vacuum tube (10) provided with an electron gun (11) emitting an electron beam which is subjected to the influence of the electric signals to be analyzed and which is controlled by a beam focusing and deflection system (12, 13), to write the trace (31-36) of the electric signals to be analyzed on the sensitive areas (23, 24) of two matrices of charge transfer devices (21, 22) in the form of stored charges which are extracted from the tube by means of read registers in order to be processed in processing circuits and then displayed in the form of electric signals reproduced on a display screen, characterized in that the two matrices (21, 22) of the charge transfer devices are juxtaposed at their sensitive areas without any interruption in accordance with a boundary which is substantially perpendicular to the scanning direction X corresponding to the time base deflection, the electron beam being deflected in accordance with a direction Y which is substantially perpendicular to the direction X by the electric signals to be analyzed so that the trace originating from the beam acts alternately on the surfaces of the sensitive areas (23, 24) of the two matrices of the charge transfer devices in accordance with trace and retrace write scan sequences (51) which are stopped by the appearance of a triggering signal upon termination of the writing cycle of the matrix on which writing is effected in order to realise a pre-triggering storing and reproducing device which permits of permanently picking up the electric signals to be analyzed and of processing these signals by processing means to provide a reproduced signal which corresponds to the part of the signal to be analyzed which precedes (31, 32) (31-34) and succeeds (32-35) (34, 35) the triggering signal (51).

2. A storing and reproducing device as claimed in Claim 1, characterized in that the two charge transfer devices (21, 22) are formed from a double charge transfer device (27) realised in the same substrate.

3. A storing and reproducing device as claimed in Claim 1 or 2, characterized in that the electron beam deflected by the deflection means (12, 13), acts directly on the surface of the charge transfer devices (21, 22) in accordance with an electron-sensitive mode.

4. A storing and reproducing device as claimed in Claim 1 or 2, characterized in that the electron beam deflected by the deflection means (11, 13) scans a cathodoluminescent display screen (17) whose emitted luminous trace scans the surface of the charge transfer devices in accordance with a photosensitive mode.

5. A storing and reproducing device as claimed in Claim 4, characterized in that each charge transfer device (21, 22) is coupled to the screen (41) with the aid of optical fibres (42, 43) which, without any discontinuity, adapt the total optical field of the screen to optical fields of sensitive areas (23, 24) of the charge transfer devices.

6. A storing and reproducing device as claimed in any one of the Claims 1 to 5, characterized in that the beam current of the tube is modulated (50) to locally write a quantity of charges in the CTD in order to create a bright dot on the display screen defining the state of a flag marker corresponding to the scanning sense of the CTD by the beam.

7. A storing and reproducing device as claimed in Claim 6, characterized in that the beam current of the tube is modulated (51) to write a further quantity of charges in the CTD in order to create a further bright dot on the display screen, defining the triggering instant.

## Patentansprüche

1. Anordnung zum Speichern und Reproduzieren zu analysierender elektrischer Signale, mit einer Vakuumröhre (10) mit einem Elektronenstrahlerzeuger (11), der einen Elektronenstrahl ausgibt, der von den zu analysierenden elektrischen Signalen beeinflußt wird und von einem Bündelfokussier- und Bündelablenksystem (12, 13) zum Einschreiben der Spur (31-36) der zu analysierenden elektrischen Signale in die empfindlichen Bereiche (23, 24) von zwei Matrizes (21, 22) ladungsgekoppelter Elemente in Form gespeicherter Ladungen gesteuert wird, wobei die gespeicherten Ladungen werden mit Hilfe von Leseregistern aus der Röhre abgeleitet werden, um in Verarbeitungsschaltungen verarbeitet und anschließend in Form auf einem Anzeigeschirm erzeugter elektrischer Signale wiedergegeben zu werden, dadurch gekennzeichnet, daß die zwei Matrizes (21, 22) des Ladungsverschiebeelements in ihren empfindlichen Bereichen (23, 24) ohne Unterbrechung entsprechend einer Begrenzung nebeneinander liegen, die im wesentlichen senkrecht auf die Abtastrichtung X entsprechend der Zeitbasisablenkung verläuft, wobei das Elektronenbündel entsprechend einer Richtung Y abgelenkt wird, die im wesentlichen senkrecht auf die X-Richtung durch die zu analysierenden elektrischen Signale verläuft, so daß die vom Bündel gezogene Spur abwechselnd auf den Oberflächen der empfindlichen Bereichen (23, 24) der zwei Matrizes des Ladungsverschiebeelements entsprechend der Spurhinlauf- und Rücklaufschreibabtastsequenzen (31-36) einwirkt, die durch das Auftreten eines Triggersignals (51) bei Beendung des Schreibzyklus der Matrix gestoppt werden, auf der das Schreiben erfolgt, um eine Frühtrigger-Aufzeichnungs- und Reproduzierschaltung zu verwirklichen, die ununterbrochenes Einfangen der zu analysierenden elektrischen Signale ermöglicht, und um ein Signal an einem Anzeigeschirm wiederzugeben, das jedem Teil des zu analysierenden Signals entspricht, der dem Erscheinen des Triggersignals (51) vorangeht (31, 32)(31-34) und nachfolgt (32-35)(34,35).

2. Schaltung zum Registrieren und Wiederherstellen mach Anspruch 1, dadurch gekennzeichnet, daß die zwei Ladungsübetragungseinrichtungen (21, 22) aus einer doppelten und auf demselben Substrat verwirklichten Ladungsübertragungseinrichtung (27) gebildet ist.

3. Schaltung zum Registrieren und Wiederherstellen mach Anspruch 1 oder 2, dadurch gekennzeichnet, daß das durch die Ablenkmittel (12, 13) abgelenkten Elektronenbündel in einem elektronenempfindlichen Betrieb direkt auf die Oberfläche der Ladungsübertragungseinrichtungen (21, 22) einwirkt.

4. Schaltung zum Registrieren und Wiederherstellen mach Anspruch 1 oder 2, dadurch gekennzeichnet, daß das durch die Ablenkmittel (12, 13) abgelenkten Elektronenbündel einen Kathodolumiszenzschirm (17) abtastet, dessen ausgesandte Leuchtspur die Oberfläche der Ladungsübertragungseinrichtungen in einem photoempfindlichen Betrieb abtastet.

5. Schaltung zum Registrieren und Wiederherstellen mach Anspruch 4, dadurch gekennzeichnet, daß jede Ladungsübertragungseinrichtung (21, 22) mittels optischer Fasern (42, 43) mit dem Schirm (41) gekoppelt ist, wobei die Fasern ohne Diskontinuitäten das gesamte optische Feld des Schirms an die optischen Felder der empfindlichen Bereiche (23, 24) der Ladungsübertragungseinrichtungen angleicht.

6. Schaltung zum Registrieren und Wiederherstellen mach Anspruch 1 bis 5, dadurch gekennzeichnet, daß der Bündelstrom der Röhre zum örtlichen Einschreiben einer Ladungsmenge in den CTD moduliert (50) wird, um einen hellen Fleck auf dem Wiedergabeschirm zu erzeugen, der den Zustand einer Flagge entsprechend der Abtastrichtung des CTD durch das Bündel definiert.

7. Schaltung zum Registrieren und Wiederherstellen mach Anspruch 6, dadurch gekennzeichnet, daß der Bündelstrom der Röhre zum Einschreiben einer anderen Ladungsmenge in den CTD moduliert (50) wird, um einen anderen hellen Fleck auf dem Wiedergabeschirm zu erzeugen, der den Triggerzeitpunkt definiert.
